# EUROPÄISCHE PATENTSCHRIFT

(11) **EP 1 239 296 B1**
(45) Veröffentlichungstag und Bekanntmachung des Hinweises auf die Patenterteilung: **14.04.2010**
(21) Anmeldenummer: 02004170.3
(22) Anmeldetag: 26.02.2002
(51) Int. Cl.: G01R 33/30

(54) **Vorrichtung zur genauen Zentrierung eines NMR-Probengläschens**
Device for accurately centering an NMR sample tube
Dispositif pour le centrage précis d'un tube à échantillon pour la RMN

(30) Priorität: 09.03.2001 DE 10111672
(43) Veröffentlichungstag der Anmeldung: 11.09.2002
(73) Patentinhaber: Bruker BioSpin AG, 8117 Fällanden (CH)
(72) Erfinder: Warden, Michael, 8118 Pfaffhausen (CH); Seydoux, Roberto, 8604 Volketswil (CH); Marek, Daniel, 5103 Möriken (CH)
(74) Vertreter: Kohler Schmid Möbus

(56) Entgegenhaltungen:
- DE-A- 3 011 479
- US-A- 5 184 078
- US-B1- 6 177 798

## Beschreibung

Die Erfindung betrifft einen NMR-Probenkopf gemäß dem Oberbegriff von Anspruch 1. Ein derartiger Probenkopf ist aus der DE 3011479 bereits bekannt, wobei dort die Empfangsspule auf der Außenseite eines rohrförmigen Einsatzes angebracht ist, durch den im Betrieb das Probenröhrchen gesteckt wird.

Ein NHR-Probenkopf mit einer Vorrichtung zur Zentrierung eines Länglichen Probenröhrchens ist auch aus der Firmenbroschüre "High Resolution NMR, Probeheads" der Bruker-Gruppe aus dem Jahr 1995 bekannt.

In der NMR-Spektroskopie ist die exakte Zentrierung eines Probenröhrchens in Bezug auf die Sende- und Empfangsspule eine wichtige Voraussetzung, um eine möglichst hohe Empfindlichkeit des Spektrometers zu erreichen. Insbesondere muss die radiale Zentrierung besonders exakt erfolgen, da zur Erreichung eines möglichst hohen Füllfaktors, der Abstand zwischen der Empfangsspule und dem Probenröhrchen so klein wie möglich sein sollte. Bei immer kleiner werdenden Probenröhrchen muss der Abstand zwischen Empfangsspule und Probenröhrchen linear kleiner werden, um denselben Füllfaktor beizubehalten, und die Anforderungen an die radiale Positionierungsgenauigkeit steigen deshalb ebenfalls linear an. Im Grenzfall, wenn das Probenröhrchen aus einer sogenannten Messkapillare besteht, sind deshalb die Anforderungen an die Genauigkeit der radialen Zentrierung ganz besonders hoch. Solche Messkapillaren werden vorwiegend dann verwendet, wenn die zur Verfügung stehende Menge an Messsubstanz sehr gering ist.

Bekannt sind Zentriervorrichtungen, die je nach Auslegung in verschiedene Genauigkeitsstufen eingeteilt werden können:

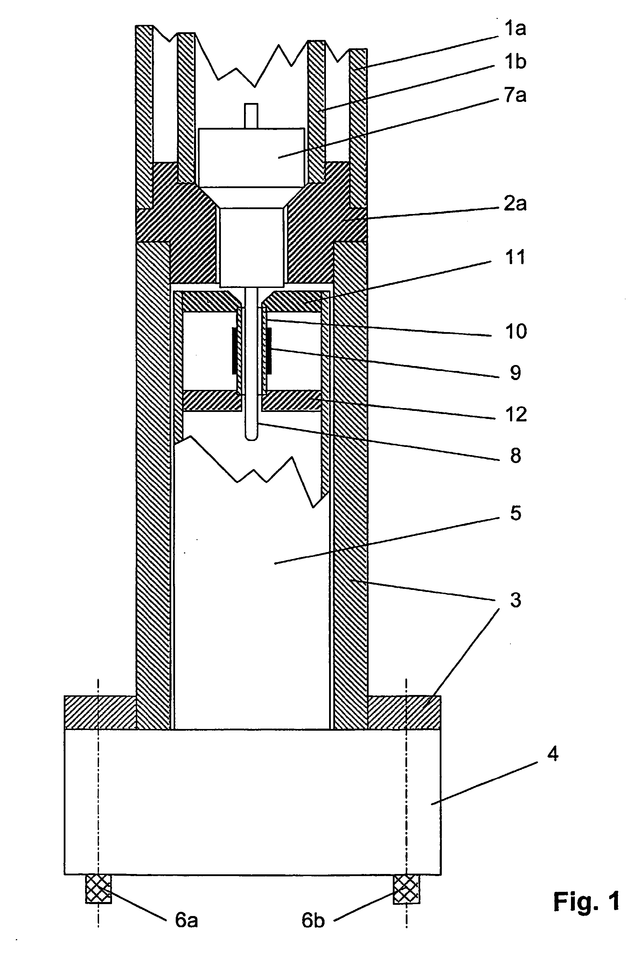

Die Genauigkeitsstufe 1 stellt die niedrigste Stufe bezüglich Genauigkeit der Zentrierung dar. Bekannt beispielsweise durch die oben zitierte Firmenbroschüre der Bruker AG ist eine Anordnung, wie sie in Fig. 1 dargestellt ist, wo das Probenröhrchen 8 in den Rotor 7a einer Luftturbine (= Spinner) gesteckt wird, und dieser Spinner auf der konischen Führungsfläche des Stators 2a der Luftturbine, die sich oberhalb der Empfangsspule 9 befindet, axial und radial zentriert wird. Der Stator mit seiner konischen Führungsfläche steht nicht in direkter mechanischer Verbindung mit der Empfangsspule, sondern ist über den unteren Trägerteil 3, anschließend über den unteren Teil des Probenkopfes 4 und schließlich über den oberen Teil 5 des Probenkopfes mit der oberen und unteren Befestigung 11, 12 des Trägerröhrchens 10 der Empfangsspule 9 verbunden. Die Position des Probenröhrchens in Bezug zur Empfangsspule ist somit von sehr vielen Einzelteilen mit verschiedenen mechanischen Toleranzen abhängig, die sich im schlimmsten Fall addieren können und dadurch die Genauigkeit und Reproduzierbarkeit der Zentrierung verschlechtern.

Insbesondere muss erwähnt werden, dass die Distanz zwischen der konischen Führungsfläche und der Empfangsspule relativ groß ist. Dies hat zur Folge, dass kleinste Winkelfehler in der Ausrichtung der Achse der konischen Führungsfläche einen großen Einfluss auf die Position des Probenröhrchens am Ort der Empfangspule haben. Dieser Einfluss ist umso größer, je größer die Distanz zwischen konischer Führungsfläche und Empfangsspule ist.

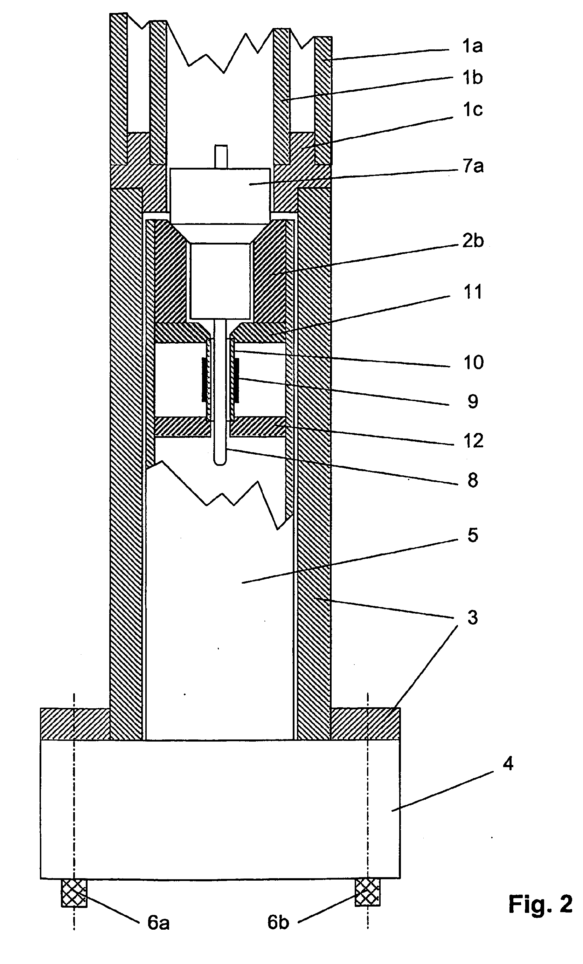

Eine Vorrichtung mit der nächsthöheren Genauigkeitsstufe 2 ist in Fig. 2 dargestellt. Sie erlaubt eine gegenüber der Vorrichtung nach Fig. 1 genauere Zentrierung des Probenröhrchens. Das Probenröhrchen steckt auch hier in einem Spinner 7a, der durch die konische Führungsfläche des Stators 2b einer Luftturbine, die sich oberhalb der Empfangsspule 9 befindet, in axialer und radialer Richtung positioniert wird. Im Gegensatz zur Anordnung von Fig. 1 ist jedoch hier der Stator mit seiner konischen Führungsfläche direkt am oberen Teil 5 des Probenkopfes befestigt. Dadurch ist die konische Führungsfläche über weniger Zwischenteile mit der Empfangsspule verbunden, und damit sind weniger mechanische Toleranzen vorhanden, die sich addieren können. Die Distanz zwischen der konischen Führungsfläche und der Empfangsspule ist jedoch wie in Fig. 1 immer noch groß, so dass Winkelfehler in der Ausrichtung der konischen Führungsfläche auch in diesem Fall zu großen Positionierungsfehlern führen können.

Eine Vorrichtung mit der noch höheren Genauigkeitsstufe 3 ist in der noch unveröffentlichten deutschen Patentanmeldung mit dem amtlichen Aktenzeichen 100 06 324.1-33 beschrieben. Das Probenröhrchen steckt auch hier in einem Spinner, der durch die konische Führungsfläche des Stators einer Luftturbine, die sich oberhalb der Empfangsspule befindet, in axialer und radialer Richtung positioniert wird. Die konische Führungsfläche ist ähnlich wie in Fig. 1 nicht direkt mit dem oberen Teil des Probenkopfes verbunden, sondern über diverse Trägerteile. Als wichtiges zusätzliches Merkmal besitzt die Vorrichtung jedoch eine zweite radiale Zentrierung, die unmittelbar unterhalb der Empfangsspule angebracht ist. Dadurch lässt sich der Einfluss des Winkelfehlers der konischen Führungsfläche praktisch vollständig beheben, trotz der Tatsache, dass die Distanz zwischen konischer Führungsfläche und Empfangsspule ähnlich groß ist wie in den Anordnungen von Fig.1 und Fig. 2.

Aus der US 5,184,078 ist eine Vorrichtung zum Rotieren eines Probenröhrchens in einer NMR-Anordnung bekannt. Das Probenröhrchen wird mittels zweier Lager, von denen eines mit einem Permanentmagneten und das andere mit einem ferromagnetischen Joch verbunden ist, in einer zur Gesamtvorrichtung zentrierten Lage gehalten.

Aufgabe der vorliegenden Erfindung ist es, mit möglichst einfachen technischen Mitteln die Zentrierungsgenauigkeit gegenüber den oben beschriebenen bekannten Vorrichtungen noch weiter zu steigern, um dadurch auch für Probengläschen in Form von Messkapillaren, bei denen die Anforderung an die Güte der Zentrierung am größten ist, optimale Resultate zu erreichen und um dadurch auch eine Erhöhung des Füllfaktors durch Reduktion des Abstands zwischen Probenröhrchen und Empfangsspule zu ermöglichen.

Erfindungsgemäß wird diese Aufgabe durch die Gesamtheit der Merkmale des Anspruchs 1 gelöst.

Durch die beiden axial voneinander beabstandeten und ausschließlich radial wirkenden Zentrierungseinrichtungen kann eine optimale radiale Zentrierung des Probenröhrchens auch dann sichergestellt werden, wenn dieses einen sehr geringen Durchmesser aufweist, wie das bei üblichen Messkapillaren der Fall ist, die bei sehr geringen zu untersuchenden Substanzmengen eingesetzt werden. Die starre mechanische Verbindung zwischen den beiden radial wirkenden Zentrierungseinrichtungen und einer Trägervorrichtung, mit der das NMR-Empfangsspulensystem seinerseits starr verbunden ist, stellt sicher, dass die radiale Zentrierung des Probenröhrchens zwangsläufig relativ zum NMR-Empfangsspulensystem erfolgt. Zusätzlich und unabhängig davon ist dann auch noch eine axiale Zentrierung vorgesehen. Damit kann insgesamt eine sehr hohe Genauigkeit der Zentrierung gewährleistet werden. Andererseits ist durch die Trennung der einzelnen Zentrierfunktionen ein besonders hoher Freiheitsgrad für die geometrische Ausgestaltung der gesamten Zentriervorrichtung vorhanden, so dass die Zentrierung geometrisch so nah wie möglich am Empfangsspulensystem bewirkt werden kann.

Eine besonders einfache Ausführungsform des erfindungsgemäßen Probenkopfes zeichnet sich dadurch aus, dass die in axialer Richtung auf Probenröhrchen wirkende Positionierungseinrichtung unterhalb des NMR-Empfangsspulensystems angeordnet ist und ein Anschlagteil umfasst, auf welchem das Probenröhrchen in Betriebsposition aufsitzt. Dadurch kann die axiale Zentrierung des Probenröhrchens technisch besonders unaufwändig, aber dennoch präzise gestaltet werden.

Alternativ dazu sieht eine weitere bevorzugte Ausführungsform vor, dass die in axialer Richtung auf das Probenröhrchen wirkende Positionierungseinrichtung oberhalb des NMR-Empfangsspulensystems angeordnet ist und eine manschettenartig und verrutschsicher radial um das Probenröhrchen herum anzubringende Befestigungshülse umfasst, die in Betriebsposition des Probenröhrchens mit einer horizontalen unteren Abschlussfläche auf einer oberhalb des NMR-Empfangsspulensystems angeordneten horizontalen Anschlagfläche eben aufliegt. Diese Ausführungsform ist zwar technisch etwas aufwändiger als die zuvor beschriebene, dafür ermöglicht sie aber eine wesentlich einfachere Handhabung des Systems im Betrieb.

Bei einer besonders vorteilhaften Weiterbildung dieser Ausführungsform ist die Anschlagfläche für die Befestigungshülse im Bodenbereich auf der Innenseite eines Rotors vorgesehen, der Teil einer Luftturbine zur Positionierung und wahlweise zur Rotation des Probenröhrchens ist und eine zentrische axiale Innenbohrung mit einem größeren Durchmesser als dem Außendurchmesser der Befestigungshülse aufweist. Die Außenmaße der Luftturbine können ohne weiteres mit denen von konventionell nach dem Stand der Technik eingesetzten Spinnern übereinstimmen, so dass das System an bereits vorhandene Pneumatikeinrichtungen automatisch angepasst ist und keine Änderungen dieses Teils der Apparatur erforderlich werden.

Die Befestigungshülse bei diesen Ausführungsformen kann durch erhöhten Reibungskontakt verrutschsicher am Probenröhrchen angebracht sein. Es kann aber auch eine feste Verbindung mit dem Probenröhrchen, insbesondere eine Verklebung oder Verschweißung vorgesehen sein, so dass ein Verrutschen der Befestigungshülse beim Auftreffen mit ihrer horizontalen Abschlussfläche auf die entsprechende Anschlagfläche absolut ausgeschlossen werden kann.

Gemäß der Erfindung sind die mindestens zwei ausschließlich in radialer Richtung auf das Probenröhrchen wirkenden Zentrierungseinrichtungen mittels in Umfangsrichtung um das Probenröhrchen in dessen Betriebsposition angeordneten, axial ausgedehnten Trägerstangen starr miteinander verbunden. Auf diese Weise lässt sich mit technisch extrem einfachen Mitteln und minimalem Materialaufwand eine starre Verbindung zwischen den beiden radial wirkenden Zentrierungseinrichtungen sicherstellen, die die Genauigkeit der Zentrierung des Probenröhrchens noch weiter erhöht.

Vorzugsweise sind die Trägerstangen symmetrisch um das Probenröhrchen herum angeordnet, was ebenfalls der Genauigkeit der Zentrierung zugute kommt.

Besonders bevorzugt sind genau drei symmetrisch um das Probenröhrchen herum angeordnete Trägerstangen vorgesehen, was einerseits für die mechanische Stabilität der starren Verbindung zwischen den beiden radialen Zentrierungseinrichtungen gerade ausreicht, andererseits viel Spielraum für die Montage des NMR-Empfangsspulensystems schafft.

Die Trägerstangen sollten in jedem Falle aus einem Material gefertigt sein, das keinen Einfluss auf die NMR-Messungen ausübt. Vorteilhafterweise kann für die Trägerstangen Keramik-, Glas- oder Quarzmaterial verwendet werden.

Das NMR-Empfangspulensystem ist ebenfalls starr an den Trägerstangen befestigt. Auf diese Weise kann mit den einfachsten technischen Mitteln und geringstmöglichem Materialeinsatz die erfindungsgemäß geforderte starre Verbindung zwischen dem NMR-Empfangsspulensystem und den beiden radial wirkenden Zentrierungseinrichtungen einerseits und die starre Verbindung zwischen den beiden radialen Zentrierungseinrichtungen untereinander andererseits durch eine einzige Befestigungsvorrichtung, nämlich die oben beschriebenen Trägerstangen bewirkt werden, was für die Genauigkeit der Zentrierung optimal ist.

Um einen möglichst großen Füllfaktor erreichen zu können, sind die Trägerstangen radial außen um das NMR-Empfangspulensystem herum angeordnet und das NMR-Empfangsspulensystem ist auf der Innenseite dieser Trägerstangen starr befestigt.

Weitere Vorteile der Erfindung ergeben sich aus der Beschreibung und der Zeichnung. Die gezeigten und beschriebenen Ausführungsformen sind nicht als abschließende Aufzählung zu verstehen, sondern haben vielmehr beispielhaften Charakter für die Schilderung der Erfindung.

Die Erfindung ist in der Zeichnung dargestellt und wird anhand von Ausführungsbeispielen näher erläutert. Es zeigen:
- Fig. 1: einen schematischen Vertikalschnitt durch einen NMR-Probenkopf nach dem Stand der Technik mit Genauigkeitsstufe 1 der Zentrierung des Probenröhrchens;
- Fig. 2: einen schematischen Vertikalschnitt durch einen NMR-Probenkopf nach dem Stand der Technik mit Genauigkeitsstufe 2 der Zentrierung des Probenröhrchens;
- Fig. 3: einen schematischen Vertikalschnitt durch einen NMR-Probenkopf mit erfindungsgemäßer Zentriervorrichtung ohne Spinner und mit unterem axialen Anschlag des Probenröhrchens;
- Fig. 4: einen schematischen Vertikalschnitt durch einen NMR-Probenkopf mit erfindungsgemäßer Zentriervorrichtung mit erfindungsgemäß modifiziertem Spinner und Befestigungshülse zur axialen Positionierung des Probenröhrchens;
- Fig. 5a: den Bereich um die NMR-Empfangsspule einer Vorrichtung nach Fig. 3 oder Fig. 4 in größerem Detail; und
- Fig. 5b: eine Horizontalschnitt längs der Linie A - A in Fig. 5a.

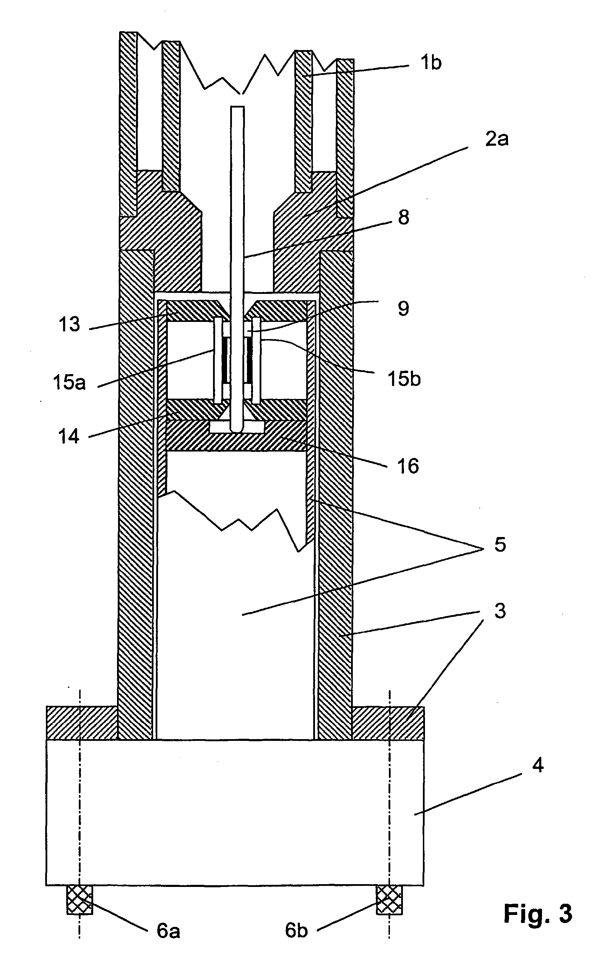

In der erfindungsgemäßen Vorrichtung wird das Probenröhrchen unmittelbar oberhalb und unterhalb der Empfangsspule mit Hilfe der beiden Zentriervorrichtungen 13 und 14 rein radial zentriert (Fig. 3). Da diese Zentrierung so nahe wie möglich bei der Empfangsspule 9 und mit möglichst wenig Zwischenteilen erfolgt, ist eine hohe Genauigkeit der Zentrierung gewährleistet. Wie nahe diese Zentrierung bei der Empfangsspule angebracht werden kann, hängt vom Einfluss der Suszeptibilät der verwendeten Materialien auf die NMR-Auflösung ab, was experimentell bestimmt werden muss.

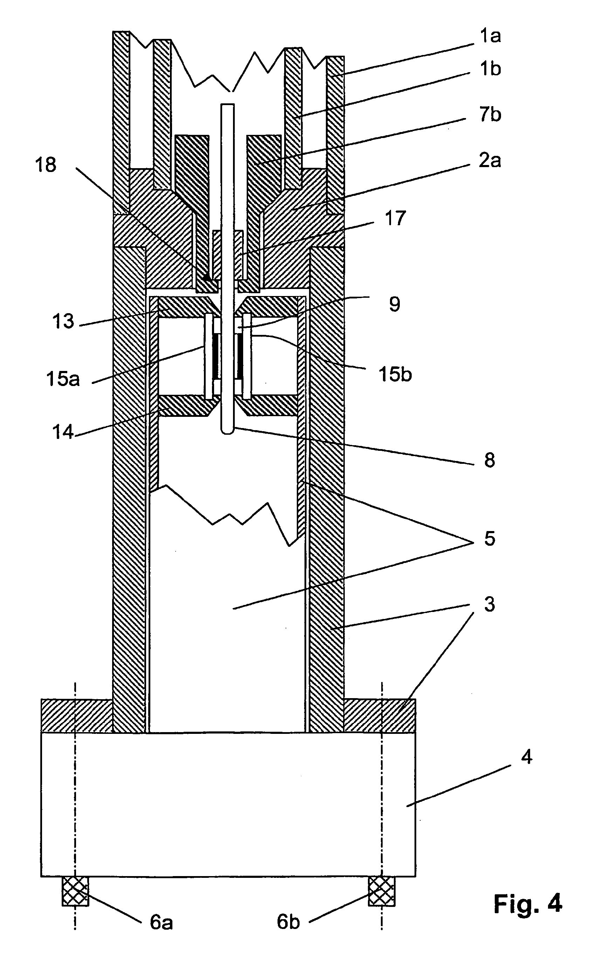

Die axiale Positionierung erfolgt getrennt, entweder unterhalb der Empfangsspule 9 mit Hilfe eines Anschlagteils 16, wie in dem Ausführungsbeispiel nach Fig. 3 gezeigt ist, oder oberhalb der Empfangsspule 9, vorzugsweise innerhalb eines modifizierten Spinners 7b, mit Hilfe einer Befestigungshülse 17, wie in Fig. 4 dargestellt.

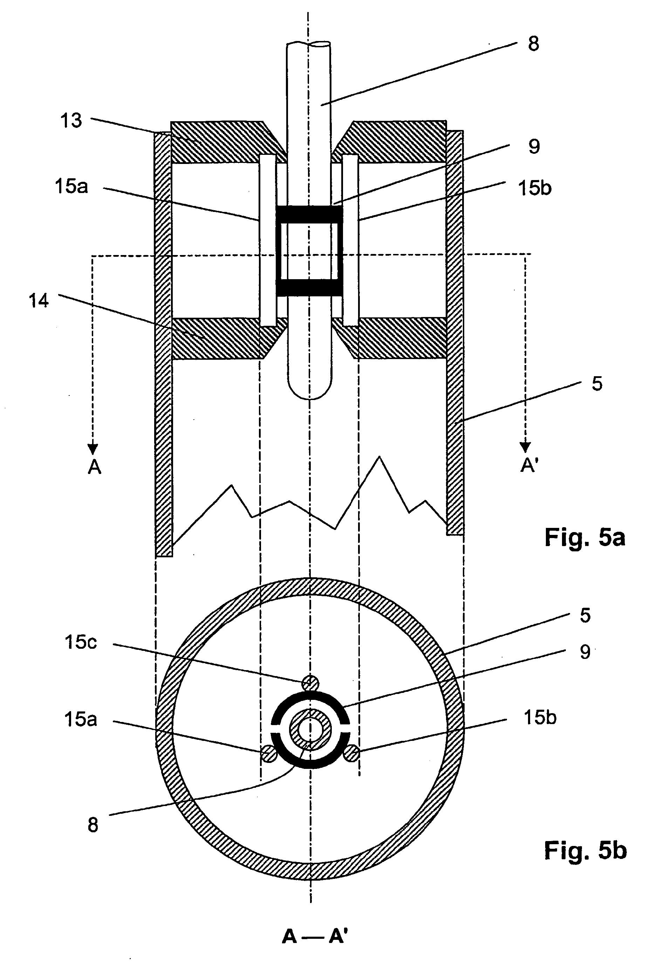

Da mit der erfindungsgemäßen Vorrichtung eine hohe radiale Zentriergenauigkeit erreicht wird, kann zudem die Empfangsspule 9 im Innern ihrer Trägervorrichtung befestigt werden, d.h. unmittelbar um das Probenröhrchen 8 herum mit einem sehr geringen Abstand zueinander, wodurch der erreichbare Füllfaktor sehr hoch wird. Dies ist in den Figuren 5a und 5b näher gezeigt. Voraussetzung für eine solche Anordnung ist jedoch die hohe radiale Zentriergenauigkeit, die eine Beschädigung der Empfangsspule 9 beim Einführen des Probenröhrchens 8 verhindert.

Die Figuren 5a und 5b zeigen, wie die Empfangsspule 9 innen an den drei Trägerstangen 15a, 15b und 15c befestigt ist, wie die Trägerstangen durch die beiden radial wirkenden Zentriervorrichtungen 13 und 14 gehalten sind, und wie die beiden Zentriervorrichtungen 13 und 14 das Probenröhrchen 8 leicht berühren und dadurch eine radiale Zentrierung unmittelbar oberhalb und unterhalb der Empfangsspule 9 erzeugen.

Fig. 3 zeigt eine Variante der erfindungsgemäßen Vorrichtung, bei der die axiale Positionierung des Probenröhrchens unterhalb der Empfangsspule 9 erfolgt, und zwar mit Hilfe des Anschlagteils 16. Diese Variante besitzt den Vorteil, sehr einfach zu sein, hat jedoch den Nachteil, dass die Einführung des Probenröhrchens 8 nicht einfach ist. Von oben ist die Einführung nur mit einer Hilfsvorrichtung möglich, da das Führungsrohr 1b des Spinners relativ lang ist. Es besteht aber auch die Möglichkeit, dass der Probenkopf 4, 5 zuerst durch lösen der Schrauben 6a, 6b entfernt, das Probenröhrchen 8 anschließend in den Probenkopf gesteckt, und zum Schluss der Probenkopf wieder mit den Schrauben 6a, 6b montiert wird.

Fig. 4 zeigt eine axiale Positionierung des Probenröhrchens 8 mit Hilfe eines leicht modifizierten Spinners, der sich oberhalb der Empfangsspule 9 befindet. Es ist eine etwas aufwändigere Lösung, die aber sehr wichtige Vorteile besitzt, wie unten näher erläutert wird. Das Probenröhrchen 8 wird zuerst straff in eine Befestigungshülse 17 gesteckt, die sogar permanent mit dem Probenröhrchen 8 verklebt oder verschweißt sein darf.

Der Spinner 7b enthält im oberen Bereich eine vergrößerte Bohrung, in der die Befestigungshülse 17 lose, d.h. mit genügend Spielraum in radialer Richtung, Platz hat. Die Verengung im unteren Bereich des Spinners, auf deren Anschlagfläche 18 die Befestigungshülse 17 zum Aufliegen kommt, erzeugt die axiale Zentrierung.

Der Spinner 7b, dessen Außenmaße mit denen der konventionellen Spinner übereinstimmen, ist an eine bestehende Pneumatik angepasst, mit der er, auf einem Luftpolster liegend, von oben durch das Führungsrohr 1b nach unten, und umgekehrt von unten wieder nach oben befördert werden kann. Da sich die Befestigungshülse 17 innerhalb des Spinners 7b frei nach oben und in einem beschränkteren Maß auch seitlich bewegen kann, besteht keine Gefahr mehr, dass beim Hinunterfahren des Spinners die leicht zerbrechliche Messkapillare auf den konischen Teil der oberen Zentriervorrichtung 13 aufprallt und dort, durch das relativ große Gewicht des Spinners, zusätzliche Kräfte erfährt, die zu ihrem Bruch führen können. Dadurch, dass keine feste Verbindung zwischen der Befestigungshülse 17 und dem Spinner 7b besteht, kann die Messkapillare auf den konischen Teil der Zentriervorrichtung 13 aufprallen und sich dort problemlos zentrieren, während sich der Spinner 7b an ihr vorbei weiter nach unten bewegt, ohne jedoch die Befestigungshülse 17 samt Messkapillare mitzureißen und dadurch zusätzliche Kräfte auf die Messkapillare auszuüben.

Es muss an dieser Stelle betont werden, dass früher sehr häufig Glasbrüche entstanden, wenn die pneumatische Einrichtung benutzt wurde, um den Spinner samt Messkapillare hinunterzufahren. Mit der erfindungsgemäßen Ausgestaltung des Spinners 7b ist dieses Problem schlagartig verschwunden.

### Bezugszeichenliste

- 1a: Oberer Trägerteil (Außenmantel)
- 1 b: Oberer Trägerteil (Führungsrohr für den Spinner)
- 1 c: Oberer Trägerteil (unterer Abschlussflansch)
- 2a: Stator der Luftturbine von Fig. 1, Fig. 3 und Fig. 4
- 2b: Stator der Luftturbine von Fig. 2
- 3: Unterer Trägerteil
- 4: Unterer Teil des Probenkopfes
- 5: Oberer Teil des Probenkopfes
- 6a, b: Befestigungsschrauben. Diese sind von Hand abschraubbar, damit der Probenkopf leicht entfernt werden kann.
- 7a: Rotor (= Spinner) der Luftturbine von Fig. 1 und Fig. 2
- 7b: Rotor (= Spinner) der Luftturbine von Fig. 4. Diese erlaubt zugleich eine reine axiale Positionierung des Probenröhrchens 8
- 8: Probenröhrchen
- 9: Empfangsspule (sattelförmig)
- 10: Trägerröhrchen der Empfangsspule
- 11: Oberer Befestigungsteil des Trägerröhrchens 10
- 12: Unterer Befestigungsteil des Trägerröhrchens 10
- 13: Obere radiale Zentriereinrichtung für das Probenröhrchen 8. Dient zugleich auch als obere Befestigung der drei Trägerstangen, 15a, 15b und 15c der Empfangsspule 9.
- 14: Untere radiale Zentriereinrichtung für das Probenröhrchen 8. Dient zugleich auch als untere Befestigung der drei Trägerstangen, 15a, 15b und 15c der Empfangsspule 9.
- 15a,b,c: Trägerstangen zur Befestigung der Empfangsspule 9
- 16: Anschlagteil zur axialen Positionierung des Probenröhrchens 8
- 17: Befestigungshülse des Probenröhrchens. Sie erlaubt eine axiale Positionierung des Probenröhrchens im Spinner.
- 18: Anschlagfläche

## Patentansprüche

1. NMR-Probenkopf mit einem sich um eine Vertikalachse herum erstreckenden NMR-Empfangsspulensystem, das in einer Trägervorrichtung starr befestigt ist, und einer Vorrichtung zur Zentrierung eines mit einer Messsubstanz gefüllten, einseitig geschlossenen, länglichen Probenröhrchens (8) relativ zur Vertikalachse des NMR-Empfangsspulensystems (9), wobei mindestens zwei in Richtung der Vertikalachse voneinander beabstandete Zentrierungseinrichtungen (13, 14) zur ausschließlich radialen Zentrierung des Probenröhrchens (8) vorgesehen sind, von denen eine oberhalb und die andere unterhalb des NMR-Empfangsspulensystems (9) angeordnet ist,
wobei mindestens eine Positionierungseinrichtung (16; 17) zur axialen Positionierung des Probenröhrchens (8) vorgesehen ist, die sich in Betriebsposition des Probenröhrchens entweder unterhalb oder oberhalb des NMR-Empfangsspulensystems (9) befinden kann, und
wobei die Zentrierungseinrichtungen (13, 14) mit der Trägervorrichtung zur Befestigung des NMR-Empfangsspulensystems (9) starr verbunden sind,
**dadurch gekennzeichnet, dass** die Zentrierungseinrichtungen mittels axial ausgedehnter Trägerstangen (15a, 15b, 15c) starr miteinander verbunden sind, die radial außen um das NMR-Empfangsspulensystem (9) herum angeordnet sind und an denen das NMR-Empfangsspulensystem (9) ebenfalls starr befestigt ist, so daß es im Betrieb nur einen sehr geringen Abstand zum Probenröhrchen (8) hat.

2. NMR-Probenkopf nach Anspruch 1, **dadurch gekennzeichnet, dass** die Positionierungseinrichtung unterhalb des NMR-Empfangsspulensystems (9) angeordnet ist und ein Anschlagteil (16) umfasst, auf welchem das Probenröhrchen (8) in Betriebsposition aufsitzt.

3. NMR-Probenkopf nach Anspruch 1, **dadurch gekennzeichnet, dass** die Positionierungseinrichtung oberhalb des NMR-Empfangsspulensystems (9) angeordnet ist und eine manschettenartig und vermrutschsicher radial um das Probenröhrchens (8) herum anzubringende Befestigungshülse (17) umfasst, die in Betriebsposition des Probenröhrchens (8) mit einer horizontalen unteren Abschlussfläche auf einer oberhalb des NMR-Empfangsspulensystems (9) angeordneten horizontalen Anschlagfläche (18) eben aufliegt.

4. NMR-Probenkopf nach Anspruch 3, **dadurch gekennzeichnet, dass** die Anschlagfläche (18) für die Befestigungshülse (17) im Bodenbereich auf der Innenseite eines Rotors (7b) vorgesehen ist, der Teil einer Luftturbine zur Positionierung und wahlweise zur Rotation des Probenröhrchens (8) ist und eine zentrische axiale Innenbohrung mit einem größeren Durchmesser als dem Außendurchmesser der Befestigungshülse (17) aufweist.

5. NMR-Probenkopf nach einem der vorhergehenden Ansprüche, **dadurch gekennzeichnet, dass** drei symmetrisch um das NMR-Empfangsspulensystem (9) herum angeordneteTrägerstangen (15a, 15b, 15c) vorgesehen sind.

6. NMR-Probenkopf nach einem der vorhergehenden Ansprüche, **dadurch gekennzeichnet, dass** die Trägerstangen (15a, 15b, 15c) aus Keramik-, Glas- oder Quarzmaterial aufgebaut sind.

## Claims

1. NMR probe head having an NMR receiver coil system extending around a vertical axis which is rigidly mounted in a support device, and a device for centering an elongated sample tube (8) being closed at one end thereof, filled with a measuring substance relative to the vertical axis of the NMR receiver coil system (9), wherein at least two centering means (13, 14) are provided which are separated from each other in a direction of the vertical axis for the exclusively radial centering of the sample tube (8), one of which is disposed above and the other below the NMR receiver coil system (9), wherein there is provided at least one positioning means (16; 17) for the axial positioning of the sample tube (8) which can either be disposed below or above the NMR receiver coil system (9) when the sample tube is in the operating position, and wherein the centering means (13, 14) are rigidly connected to the support device for mounting the NMR receiver coil system (9),
**characterized in**
**that** the centering means are rigidly connected to each other by means of axially extended support bars (15a, 15b, 15c) which are radially disposed in the circumferential direction around the NMR receiver coil system (9), and to which the NMR receiver coil system (9) is also rigidly connected so that during operation it only has a very minor distance to the probe tube (8).

2. NMR probe head according to claim 1, **characterized in that** the positioning means is disposed below the NMR receiver coil system (9) and comprises a stop part (16) on which the sample tube (8) is supported in the operating position.

3. NMR probe head according to claim 1, **characterized in that** the positioning means is disposed above the NMR receiver coil system (9) and comprises a mounting sleeve (17) which is to be disposed like a collar radially around the sample tube (8) such that it cannot slip, and which flatly abuts with a lower horizontal end face on a horizontal stop surface (18) disposed above the NMR receiver coil system (9) in the operating position of the sample tube (8).

4. NMR probe head according to claim 3, **characterized in that** the stop surface (18) for the mounting sleeve (17) is provided in the bottom region on the inner side of a rotor (7b) which is part of an air turbine for positioning and optionally rotating the sample tube (8) and has a central axial inner bore having a larger diameter than the outer diameter of the mounting sleeve (17).

5. NMR probe head according to any one of the preceding claims, **characterized in that** three support bars (15a, 15b, 15c) are disposed symmetrically around the NMR receiver coil system (9).

6. NMR probe head according to any one of the preceding claims, **characterized in that** the support bars (15a, 15b, 15c) are made from a ceramic, glass or quartz material.

## Revendications

1. Tête d'échantillonnage RMN avec un système de bobines de réception RMN s'étendant autour d'un axe vertical, qui est fixé rigidement dans un dispositif de support, et un dispositif pour centrer une éprouvette (8) fermée d'un côté, remplie d'une substance à mesurer, allongée par rapport à l'axe vertical du système de bobines de réception RMN (9), dans laquelle tête d'échantillonnage RMN sont prévus au moins deux dispositifs de centrage (13, 14) espacés l'un de l'autre dans la direction de l'axe vertical pour le centrage exclusivement radial de l'éprouvette (8), dont l'un est disposé au-dessus et l'autre au-dessous du système de bobines de réception RMN (9), dans laquelle tête d'échantillonnage RMN est prévu au moins un dispositif de positionnement (16 ; 17) pour le positionnement axial de l'éprouvette (8), qui, en position d'utilisation de l'éprouvette, peut se trouver soit au-dessous, soit au-dessus du système de bobines de réception RMN (9), et dans laquelle tête d'échantillonnage RMN les dispositifs de centrage (13, 14) sont reliés rigidement au dispositif de support pour fixer le système de bobines de réception RMN (9),
**caractérisée en ce que**
les dispositifs de centrage sont reliés rigidement l'un à l'autre au moyen de tiges de support (15a, 15b, 15c) étendues axialement qui sont disposées radialement extérieurement autour du système de bobines de réception RMN (9) et auxquelles le système de bobines de réception RMN (9) est également fixé rigidement, de manière à n'avoir qu'un très faible écartement par rapport à l'éprouvette (8) en utilisation.

2. Tête d'échantillonnage RMN selon la revendication 1, **caractérisée en ce que** le dispositif de positionnement est disposé au-dessous du système de bobines de réception RMN (9) et comprend une pièce de butée (16) sur laquelle repose l'éprouvette (8) en position d'utilisation.

3. Tête d'échantillonnage RMN selon la revendication 1, **caractérisée en ce que** le dispositif de positionnement est disposé au-dessus du système de bobines de réception RMN (9) et comprend un manchon de fixation (17) à installer à la manière d'une manchette et sans possibilité de glissement radial autour de l'éprouvette (8), lequel, en position d'utilisation de l'éprouvette (8), repose de niveau avec une surface terminale inférieure horizontale sur une surface de butée (18) horizontale disposée au-dessus du système de bobines de réception RMN (9).

4. Tête d'échantillonnage RMN selon la revendication 3, **caractérisée en ce que** la surface de butée (18) pour le manchon de fixation (17) est prévue dans la zone de fond du côté intérieur d'un rotor (7b) qui fait partie d'une turbine à air servant au positionnement et, au choix, à la rotation de l'éprouvette (8) et présente un perçage intérieur axial centré d'un plus grand diamètre que le diamètre extérieur du manchon de fixation (17).

5. Tête d'échantillonnage RMN selon une des revendications précédentes, **caractérisée en ce que** trois tiges de support (15a, 15b, 15c) disposées symétriquement autour du système de bobines de réception RMN (9) sont prévues.

6. Tête d'échantillonnage RMN selon une des revendications précédentes, **caractérisée en ce que** les tiges de support (15a, 15b, 15c) sont constituées de céramique, verre ou quartz.
